# EUROPÄISCHE PATENTSCHRIFT

(11) **EP 2 838 172 B1**
(45) Veröffentlichungstag und Bekanntmachung des Hinweises auf die Patenterteilung: **28.11.2018**
(21) Anmeldenummer: 14179145.9
(22) Anmeldetag: 30.07.2014
(51) Int. Cl.: H02H 1/00, H02H 3/04, G01R 31/327

(54) **VORRICHTUNG UND VERFAHREN ZUR DETEKTION VON STÖRLICHTBÖGEN**
DEVICE AND METHOD FOR DETECTING ARCING FAULTS
DISPOSITIF ET PROCÉDÉ DESTINÉS À LA DÉTECTION D'ARCS ÉLECTRIQUES PARASITES

(30) Priorität: 14.08.2013 DE 102013216096
(43) Veröffentlichungstag der Anmeldung: 18.02.2015
(73) Patentinhaber: Availon GmbH, 48429 Rheine (DE)
(72) Erfinder: Brand, Niels, 22147 Hamburg (DE); Feddersen, Lorenz-Theo, 25853 Drelsdorf (DE)
(74) Vertreter: Grünecker Patent- und Rechtsanwälte PartG mbB

(56) Entgegenhaltungen:
- EP-A1- 2 175 536
- WO-A1-88/08217
- FR-A1- 2 914 122
- US-A1- 2010 072 355
- US-B1- 6 426 634

## Beschreibung

Die Erfindung betrifft eine Vorrichtung und ein Verfahren zur Detektion von Störlichtbögen.

Störlichtbögen können in elektrotechnischen Anlagen, wie beispielsweise Nieder-, Mittel- oder Hochspannungsschaltanlagen, auftreten. Ein Störlichtbogen ist ein Schaltlichtbogen, der ungewollt zwischen zwei elektrischen Potenzialen entsteht und dafür sorgt, dass der Strom weiterfließt. Dabei wird das Medium, das sich zwischen den beiden elektrischen Potenzialen befindet, ionisiert. Am häufigsten ist das ionisierte Medium Luft, dass bei der Ionisation Hitze und Licht emittiert, und eine Druckwelle verursacht.

Häufige Ursachen für Störlichtbögen sind beispielweise beschädigte Leitungsisolationen, Blitzspannungen, Kabelbruch, lose Kontakte, Schaltüberspannungen, Feuchtigkeit, Verschmutzung, Fehlschalthandlungen, defekte Anschlussverbindungen oder Gerätefehler. Da die Ursachen für einen Störlichtbogen derart vielfältig sind und die Entstehung eines Störlichtbogens niemals ausgeschlossen ist, müssen Störlichtbogen möglichst schnell nach deren Entstehung gelöscht werden, indem der elektrische Strom zwischen den beiden elektrischen Potenzialen unterbrochen wird, beispielsweise durch die Abschaltung einer Spannungsschaltanlage.

Wird der Störlichtbogen nicht unterbunden, können mechanische und elektrische Bauteile, die sich in der Nähe des Störlichtbogens befinden, durch Druckwellen oder Hitze verformt oder zerstört werden. Die hohen Temperaturen können sogar dazu führen, dass sich umliegende Bauteile entzünden und ein dadurch entstehender Brand eine Beschädigung von Geräten, Anlagen oder Gebäuden verursacht. Ferner sind Personenschäden durch Druckwellen oder Strahlungsweinwirkungen des Störlichtbogens möglich. Dabei gilt, je länger die Einwirkdauer des Störlichtbogens ist, desto größer ist der Schaden an Gegenständen oder Personen.

Entsprechend der spezifischen Merkmale eines Störlichtbogens, kann dieser durch optische, thermische oder druckempfindliche Sensoren detektiert werden. Bei Detektion kann ein Signal an beispielsweise eine Schalteinrichtung weitergeleitet werden, die dann für die Unterbrechung des Störlichtbogens durch Abschalten einer Spannungsanlage sorgt.

In Mittelspannungsschaltanlagen von Windenergieanlagen werden optische Störlichtbogenerkennungssysteme zum Detektieren und Unterbinden von Störlichtbögen eingesetzt. Der in dem Stromgenerator erzeugte Strom wird über einen Leistungsschrank an einen Transformator weitergeleitet. Der Transformator hat die Aufgabe, die Wechselspannung von 10kV-20kV (Mittelspannungsbereich) auf 110kV-380kV (Hochspannungsbereich) zu erhöhen. Bei neueren Windenergieanlagen befindet sich der Transformator in einem separaten Raum im hinteren Teil des Maschinenhauses oder im Turmfuß. Um Beschädigungen durch Störlichtbögen im Transformatorraum zu vermeiden, werden auch hier Störlichtbogenerkennungssysteme eingesetzt, die bei Detektion eines Störlichtbogens eine außerhalb des Transformatorraumes angeordnete Schalteinrichtung aktiviert, die dann die Abschaltung der Mittelspannungsschaltanlage - und somit auch des Transformators - bewirkt. Zur Gewährleistung der Funktionstüchtigkeit sollten diese Störlichtbogenerkennungssysteme einer regelmäßigen Prüfung unterzogen werden.

Aus dem Stand der Technik sind Störlichtbogenerkennungssysteme bekannt. Beispielsweise offenbart die DE 196 17 193 C2 eine Vorrichtung zum optischen Erfassen von Störlichtbögen, wobei eine Kugel aus optisch leitenden Material einen auftretenden Störlichtbogen über einen Lichtwellenleiter an eine Lichtbogenauswerteeinheit weiterleitet, die ein Signal erzeugt, das einer Steuereinheit zugeführt wird. Die Steuereinheit kann zum Abschalten der Schaltanlage benutzt werden. Durch einen zweiten Lichtwellenleiter können Prüflichtimpulse - als Simulation eines Störlichtbogens - von einem Prüflicht, das durch einen Prüfgenerator erzeugt wird, in die Kugel eingekoppelt werden, wodurch die wesentlichen Teile der Kugel, die Lichtbogenauswerteeinheit, der photoelektrische Sensor und der Lichtwellenleiter getestet werden können. Das von dem photoelektrischen Sensor an die Lichtbogenauswerteeinheit gesendete Signal wird nach Intensität, Anstiegsdauer und Dauer bewertet. Das von dem Prüfgenerator ausgesandte Lichtsignal hat eine geringere Intensität als eine Lichtbogenentladung. Die Lichtbogenauswerteeinheit unterscheidet zwischen Prüflicht und Störlichtbogen und verhindert im Falle einer Prüflichtdetektion ein Abschalten der Schaltanlage.

Die DE 44 40 281 C2 betrifft eine Einrichtung zur optischen Erfassung von Störlichtbogenentladungen, bei der Prüflichtimpulse zur Vortäuschung eines Störlichtbogens generiert werden. Fällt eines der Bauelemente in der aus der Lichtquelle, dem Prüfgenerator, dem Sensorelement und dem Prüfempfänger bestehenden Kette aus, wird von einer Steuereinrichtung eine Fehlermeldung ausgegeben.

Die DE 195 34 403 C2 betrifft einen Lichtbogenwächter, der einen Lichtbogen, insbesondere in Mittelspannungsschaltanlagen, detektiert. Es wird eine Testlichtquelle beschrieben, die selbsttätig über eine in einer Auswerteeinheit gesteuerten Überwachungsroutine eingeschaltet wird. Beim Einschalten der Testlichtquelle wird das Auslösesignal zur Schalteinrichtung gesperrt, so dass ein Abschalten der Mittelspannungsschaltanlage nicht bewirkt wird.

Auch die DE 295 03 914 offenbart eine Störlichtbogen-Erfassungseinrichtung. Zum Selbsttest ist dieser mit einem Prüflichtsender ausgestattet, welcher innerhalb einer Testzeit periodisch sich wiederholende Prüflichtimpulse sendet. Während der Testphase ist das Schalt- oder Schutzgerät gesperrt, so dass ein Schaltvorgang, wie er bei einem detektierten Störlichtbogen erfolgen würde, nicht eintritt.

Die US 2010/0072355, die den Oberbegriff des Anspruchs 1 formt, beschreibt ein Verfahren für die automatische Prüfung eines Störlichtbogen-Erfassungssystems durch periodisches oder durchgängiges Übersenden von elektro-optischer (EO) Strahlung durch ein oder mehrere Übertragungskabel, die elektro-optisch mit jeweiligen EO-Strahlungskollektoren gekoppelt sind.

Die WO 88/08217 betrifft ein Lichtbogen-Relais, das ausgebildet ist, einen Lichtbogen, der möglicherweise an einem oder mehreren Punkten einer Schaltanlage aufblitzt, auszulöschen, indem ein Stromunterbrecher dazu gebracht wird, die Stromversorgung zu der Schaltanlage zu öffnen.

Diese existierenden Lösungen sind jedoch aufwändig und fehleranfällig und haben sich in der Praxis nicht durchgesetzt.

Zur Gewährleistung der Funktionstüchtigkeit insbesondere von in Windenergieanlagen verbauten Störlichtbogenerkennungssystemen werden diese vielmehr einer regelmäßigen Prüfung durch einen fachkundigen Elektroinstallateur unterzogen. Der Elektroinstallateur hat dabei die Richtlinie VDE 0105 zu befolgen, durch die sich die Prüfung in eine Vielzahl von Verfahrensschritten gliedert. Dieses in der Praxis verbreitete Prüfungsverfahren ist zeit- und aufgrund der hohen Dauer der Prüfung und der damit verbundenen langen Inanspruchnahme des Elektroinstallateurs bzw. eines Teams aus mindestens zwei Elektroinstallateuren kostenintensiv. Es erfordert in der Regel das mehrmalige Betreten des vielleicht nicht spannungsfreien Transformatorraumes, wodurch der Elektroinstallateur der Gefahr eines Stromschlags ausgesetzt ist. Zudem ist es möglich, dass bei größeren und verwinkelten Transformatorräumen mehr als zwei optische Störlichtbogensensoren eingesetzt werden, was den Arbeitsaufwand und damit auch die Kosten erhöht.

Es ist daher Aufgabe der vorliegenden Erfindung, eine Vorrichtung und ein Verfahren zur Detektion von Störlichtbögen bereitzustellen, die einen oder mehrere der genannten Nachteile verringern oder beseitigen. Des Weiteren ist es Aufgabe der vorliegenden Erfindung, eine Vorrichtung und ein Verfahren bereitzustellen, die die Detektion von Störlichtbögen und/oder das Nachrüsten von Mittelspannungsschaltanlagen von Windenenergieanagen, vereinfachen und/oder, insbesondere hinsichtlich der Sicherheit, verbessern.

Diese Aufgabe wird erfindungsgemäß gelöst durch eine Vorrichtung zur Detektion von Störlichtbögen, umfassend einen optischen Sensor, welcher ausgebildet ist, um einen Störlichtbogen zu detektieren und bei Detektion eines Störlichtbogens ein Detektionssignal zu generieren und zu senden, eine Schalteinrichtung, ein Leuchtmittel, und einen Prüftaster, wobei das Leuchtmittel ausgebildet ist, bei Betätigung des Prüftasters einen Prüflichtstrahl zu emittieren, und wobei der optische Sensor ausgebildet ist, den von dem Leuchtmittel emittierten Prüflichtstrahl zu detektieren und bei Detektion des Prüflichtstrahls ein Detektionssignal zu generieren und zu senden, und wobei die Schalteinrichtung ausgebildet ist, bei Empfang des Detektionssignals die elektrisch leitende Verbindung zu trennen.

Die erfindungsgemäße Vorrichtung unterscheidet sich von existierenden Lösungen unter anderem darin, dass die Testvorrichtung auch eine Prüfung einer Schalteinrichtung einschließt, indem auch bei Detektion des Prüflichstrahls ein Detektionssignal generiert und gesendet wird, das zu einer Abschaltung der Spannungsschaltanlage führt.

Weiterhin unterscheidet sich die erfindungsgemäße Vorrichtung von existierenden Lösungen darin, dass die Vorrichtung zum Detektieren von Störlichtbögen einen einfachen Aufbau mit einer geringen Anzahl an Bauteilen aufweist. Damit wird auch das Nachrüsten bereits bestehender Störlichtbogenerkennungssysteme in Spannungsschaltanlagen durch die erfindungsgemäße Vorrichtung vereinfacht.

Die erfindungsgemäße Vorrichtung setzt einen optischen Sensor zur Detektion von Störlichtbögen ein, beispielsweise in Mittelspannungsschaltanlagen von Windenergieanlagen. Bei der Entstehung eines Schaltlichtbogens wird Licht emittiert, das durch optische Sensoren, die in einem separaten Transformatorraum installiert sind, empfangen wird. Das einfallende Licht wird in dem optischen Sensor vorzugsweise in einen Photostrom umgewandelt, welcher vorzugsweise in Form eines elektrischen Signals mittels eines elektrischen Leiters an eine Schalteinrichtung geleitet wird. Die Schalteinrichtung, die sich z.B. in einem Schaltschrank außerhalb des Transformatorraumes befindet, trennt bei Empfang des vorzugsweise elektrischen Detektionssignals eine elektrisch leitende Verbindung in dem Schaltschrank und bewirkt damit eine Unterbindung des Störlichtbogens.

Die erfindungsgemäße Vorrichtung zur Detektion von Störlichtbögen weist zusätzlich zu einem optischen Sensor und einer Schalteinrichtung ein Leuchtmittel und einen Prüftaster auf. Der optische Sensor und das Leuchtmittel sind vorzugsweise in einem Transformatorraum angeordnet. Der Prüftaster und die Schalteinrichtung sind vorzugweise außerhalb eines Transformatorraums, z.B. an einem Schaltkasten angeordnet. Der optische Sensor ist vorzugsweise mittels eines ersten Kabels mit der Schalteinrichtung verbunden. Mittels eines zweiten Kabels ist der Prüftaster vorzugsweise mit dem Leuchtmittel verbunden.

Das Leuchtmittel, das als Lichtquelle dient, emittiert im Normalbetrieb der Windenergieanlage kein Licht. Als Normalbetrieb wird in diesem Fall der Betrieb bezeichnet, wenn keine Prüfung der Vorrichtung zur Detektion von Störlichtbögen erfolgt.

Erst bei Betätigung eines Prüftasters wird das Leuchtmittel aktiviert, so dass das Leuchtmittel einen Prüflichtstrahl emittiert. Der Prüftaster ist vorzugsweise ein Taster, der nach Wegnahme der Betätigung seine Ruhestellung einnimmt. In Ruhestellung ist eine elektrische leitende Verbindung vorzugsweise getrennt. Bei Betätigung des Tasters ist vorzugsweise eine elektrisch leitende Verbindung hergestellt. Dafür ist ein erster Kontakt des Tasters mit einer Stromquelle verbunden und über einen zweiten Kontakt des Tasters besteht eine elektrische Verbindung zu dem Leuchtmittel. Ist ein Emittieren eines Prüflichtsignals beabsichtigt, muss die elektrisch leitende Verbindung in dem Taster hergestellt sein, so dass eine elektrische Verbindung zwischen der Stromquelle und dem Leuchtmittel besteht.

Der Prüflichtstrahl ist vorzugsweise eine elektromagnetische Strahlung, die ein Spektrum von 380 nm bis 780 nm Wellenlänge aufweisen kann. Als Prüflichtstrahl kann auch eine elektromagnetische Strahlung im Infrarotbereich, d.h. in einem Spektrum von 780 nm bis 1 mm, eingesetzt werden. Die Verwendung einer elektromagnetischen Strahlung im für den Menschen sichtbaren Bereich ist jedoch bevorzugt, um bei einer Wartung einen Defekt des Leuchtmittels einfach überprüfen bzw. ausschließen zu können.

Der optische Sensor detektiert den von dem Leuchtmittel ausgesandten Prüflichtstrahl. Bei Empfang des Prüflichtsignals erzeugt der optische Sensor ein Detektionssignal. Das Detektionssignal ist vorzugsweise ein elektrisches Signal, das dadurch entsteht, dass das einfallende Licht im optischen Sensor in einen Photostrom umgewandelt wird. Zu diesem Zweck weist der optische Sensor vorzugsweise Photozellen auf, wie unten insbesondere mit Bezug auf das Detektionsmedium beschrieben wird. Damit gewährleistet ist, dass ein Prüflichtsignal zu einer Generierung des Detektionssignals führt, sind der optische Sensor und das Leuchtmittel vorzugsweise so angeordnet, dass ausreichend einfallendes Licht zur Erzeugung eines Photostroms den Photozellen zugeführt wird.

Nach Erzeugung des Detektionssignals überträgt der optische Sensor das Detektionssignal an die Schalteinrichtung. Zum Senden des Detektionssignals weist der optische Sensor eine Sendeeinheit auf. Die Übertragung erfolgt vorzugsweise über ein Kabel, welches an einem ersten Ende mit dem optischen Sensor und an einem zweiten Ende mit der Schalteinrichtung verbunden ist. Das Kabel dient dazu, das Detektionssignal zu der Schalteinrichtung zu transportieren. Die Schalteinrichtung empfängt das Detektionssignal und unterbricht eine elektrisch leitende Verbindung. Zum Empfangen des Detektionssignals weist die Schalteinrichtung eine Empfängereinheit auf.

Die Erfindung hat unter anderem den Vorteil, dass eine regelmäßige Funktionsprüfung insbesondere von in Mittelspannungsschaltanlagen von Windenergieanlagen eingesetzten optischen Sensoren erheblich vereinfacht werden kann. Beispielsweise können durch die erfindungsgemäße Lösung eine große Anzahl der folgenden Schritte, die bei einer Funktionsprüfung unter Einhaltung der Richtlinie VDE 0105 erforderlich wären, eingespart oder vereinfacht werden:
1. Anlegen der erforderlichen Schutzausrüstung
2. Testen der Funktion einer Mittelspannungsprüflanze mittels des Eigenfunktionstests
3. Prüfen der korrekten Anzeige der vorhandenen Spannung im Transformatorraum
4. Freischalten der Mittelspannungsschaltanlage, um die Mittelspannungsschaltanlage selbst und den Transformatorraum spannungsfrei zu setzen
5. Sichern der Mittelspannungsschaltanlage vor dem Wiedereinschalten
6. Prüfen der Spannungsfreiheit im Transformatorraum mittels Mittelspannungsprüflanze
7. Erden und kurzschließen der Mittelspannungsanlage und des Transformators im Falle der Spannungsfreiheit
8. Abdecken eines ersten optischen Störlichtbogensensors, um dessen Auslösung durch einfallendes Licht zu verhindern
9. Entfernung der Erdung und Wiedereinschalten der Spannungsschaltanlage
10. Simulierung eines Störlichtbogens, indem mittels eines Blitzlichtgerätes ein Blitzlicht von außerhalb des Transformatorraumes erzeugt wird
11. Automatische Abschaltung der Mittelspannungsschaltanlage bei störfreier Funktion des ersten optischen Störlichtbogensensors
12. Prüfen der korrekten Anzeige der vorhandenen Spannung im Transformatorraum
13. Sichern der Mittelspannungsschaltanlage vor dem Widereinschalten
14. Prüfen der Spannungsfreiheit im Transformatorraum mittels Mittelspannungsprüflanze
15. Erden und kurzschließen der Mittelspannungsanlage und des Transformators im Falle der Spannungsfreiheit
16. Entfernen der Abdeckung des ersten Störlichtbogensensors und abdecken eines zweiten optischen Störlichtbogensensors, um eine Auslösung durch einfallendes Licht zu verhindern
17. Entfernung der Erdung und Wiedereinschalten der Mittelspannungsschaltanlage
19. Simulierung eines Störlichtbogens, indem mittels eines Blitzlichtgerätes ein Blitzlicht von außerhalb des Transformatorraumes erzeugt wird
20. Automatische Abschaltung der Mittelspannungsschaltanlage bei störfreier Funktion des zweiten optischen Störlichtbogensensors
21. Prüfen der korrekten Anzeige der vorhandenen Spannung im Transformatorraum
22. Sichern der Mittelspannungsschaltanlage vor dem Wiedereinschalten
23. Prüfen der Spannungsfreiheit im Transformatorraum mittels Mittelspannungsprüflanze
24. Erden und kurzschließen der Mittelspannungsanlage und des Transformators im Falle der Spannungsfreiheit
23. Abdeckung des zweiten optischen Störlichtbogensensor entfernen
24. Entfernung der Erdung und Wiedereinschalten der Spannungsschaltanlage
25. Prüfung von zwei Störlichtbogensensoren abgeschlossen

Bevorzugt ist, dass die Vorrichtung ausgebildet ist, im Mittelspannungsnetz, vorzugsweise bei Mittelspannungsschaltanlagen von Windenergieanlagen, eingesetzt zu werden. Die Spannung des Mittelspannungstransformator bei Windenergieanlagen kann 10 kV, 20 kV, 30 kV oder 33 kV betragen und bildet eine wichtige Spannungsebene bei Windenergieanlagen. Wesentliche Bauteile einer Windenergieanlage zur Stromerzeugung sind der Stromgenerator, Leistungsschränke und der Transformatorraum. Die Mittelspannungsschaltanlage besteht meist aus mehreren Leistungsschränken. Mittels der Mittelspannungsschaltanlage können die elektrischen Verbindungen zwischen den einzelnen elektrotechnischen Bauteilen einer Windkraftenergieanlage hergestellt oder getrennt werden. Zum Schutz der elektrotechnischen Bauteile, insbesondere der Mittelspannungsschaltanlage und des Transformators, sind optische Sensoren zur Detektion von Störlichtbögen an oder in der Nähe dieser Anlagenbauteile angeordnet, um Beschädigungen durch Störlichtbögen zu vermeiden oder zu mindern.

Besonders bevorzugt ist, dass der optische Sensor und das Leuchtmittel einer ersten Baugruppe zugeordnet sind, und die Schalteinrichtung und/oder der Prüftaster einer zweiten Baugruppe zugeordnet sind, wobei vorzugsweise die erste Baugruppe und die zweite Baugruppe voneinander räumlich getrennt sind, also beispielsweise über eine bestimmte Distanz von einander beabstandet. Eine räumliche Trennung schließt eine Verbindung der beiden Baugruppen nicht aus. Die erste Baugruppe, bestehend aus dem optischen Sensor und dem Leuchtmittel, ist vorzugsweise in einem Transformatorraum installiert. Der Transformatorraum ist ein separater Raum, in dem der Transformator platziert ist. In einem zweiten Raum ist die Mittelspannungsschaltanlage angeordnet, an der vorzugsweise der Prüftaster und die Schalteinrichtung angeschlossen sind.

Eine weitere bevorzugte Ausgestaltung sieht vor, dass die erste Baugruppe und die zweite Baugruppe, vorzugsweise signaltechnisch, miteinander verbunden sind, insbesondere kabellos oder kabelgebunden. Der optische Sensor ist vorzugsweise mit der Schalteinrichtung über eine erste Leitung verbunden, wobei ein erstes Ende der ersten Leitung mit dem optischen Sensor verbunden ist und ein zweites Ende der ersten Leitung mit der Schalteinrichtung verbunden ist. Die erste Leitung hat vorzugsweise die Aufgabe, das Detektionssignal zu übermitteln. Dabei sendet der optische Sensor das Detektionssignal in Richtung der Schalteinrichtung.

Alternativ kann eine kabellose Verbindung zwischen dem optischen Sensor und der Schalteinrichtung bestehen, indem beispielsweise Funkwellen von dem optischen Sender ausgesendet und durch die Schalteinrichtung empfangen werden.

Das Leuchtmittel ist vorzugsweise mit dem Prüftaster über eine zweite Leitung verbunden, wobei ein erstes Ende der zweiten Leitung mit dem Leuchtmittel verbunden ist und ein zweites Ende der zweiten Leitung mit dem Prüftaster verbunden ist. Der Prüftaster ist vorzugsweise mittels einer dritten Leitung mit der Stromquelle verbunden. Bei Betätigung des Prüftasters leiten vorzugsweise die zweite und die dritte Leitung den Strom von der Stromquelle zu dem Leuchtmittel.

Alternativ kann eine kabellose Verbindung zwischen dem Prüftaster und dem Leuchtmittel bestehen, indem beispielsweise Funkwellen bei Betätigung des Prüftasters ausgesandt und durch das Leuchtmittel empfangen werden. Dafür ist das Leuchtmittel vorzugsweise mit einer Batterie verbunden.

Ferner ist bevorzugt, dass das emittierte Prüflichtsignal eine Lichtintensität von 400cd bis 2000cd aufweist. Insbesondere ist bevorzugt, dass das emittierte Prüflichtsignal eine mindestens genauso hohe Lichtintensität wie das Störbogenlicht aufweist.

Eine bevorzugte Ausgestaltung ergibt sich, wenn das Leuchtmittel eine Leuchtdiode (LED) ist, die vorzugsweise in SMD-Bauweise hergestellt ist. SMD steht für "surfacemounted device", d.h. eine Leuchtdiode in SMD-Bauweise ist ein oberflächenmontiertes Bauelement bzw. eine oberflächenmontierte LED. Das in der LED angeordnete Halbleiterelement kann verschiedene Materialien aufweisen, mit denen unterschiedliche Farben des Lichts erzeugt werden können. Vorzugsweise ist die LED eine SMD-LED, die durch ihre Bauart und ihre geringere Größe wenig Platz in Anspruch nimmt. Eine Anordnung des optischen Sensors und der SMD-LED auf kleinem Bauraum ist somit möglich.

Besonders bevorzugt ist es, dass das Prüflichtsignal eine Beleuchtungsstärke von ca. 5000 bis 15000 Lux aufweist, insbesondere von mindestens 6000 Lux, besonders bevorzugt sind mindestens 12000, Lux. Ferner ist eine Zusammenfassung des optischen Sensors und des Leuchtmittels (insbesondere, wenn dieses als Leuchtdiode ausgebildet ist) in einer ersten Baugruppe, da hierbei ein sehr geringen Abstand zwischen Leuchtmittel und Detektionsmedium realisiert werden und dadurch eine hohe Beleuchtungsstärke, insbesondere in den vorgenannten bevorzugten Bereichen, erreicht werden kann.

Ferner ist eine Ausgestaltung bevorzugt, bei der Prüftaster und/oder eine Stromquelle in der Schalteinrichtung integriert sind. Der Prüftaster befindet sich vorzugsweise an einer äußeren Oberfläche der Schalteinrichtung, so dass dieser durch einen menschlichen Finger gut zugänglich und leicht betätigbar ist. Die Stromquelle ist vorzugsweise getrennt von der Schalteinrichtung angeordnet und über Kabel mit dieser verbunden. Alternativ ist die Stromquelle in der Schalteinrichtung eingebaut.

Des Weiteren ist bevorzugt, dass der Prüftaster und/oder die Stromquelle auf einer Hutschiene des Schaltschrankes montiert sind. Der Prüftaster ist somit getrennt von der Schalteinrichtung angebracht. Die Stromquelle kann entweder auf der Hutschiene oder innerhalb des Schaltschrankes angeordnet sein.

Eine weitere Ausgestaltung ist gekennzeichnet durch zwei, drei oder mehrere optische Sensoren und vorzugsweise zwei, drei oder mehrere Prüftaster sowie vorzugsweise zwei, drei oder mehrere Leuchtmittel. Die Anzahl an optischen Sensoren entspricht vorzugsweise der Anzahl an Prüftastern, so dass jeweils ein optischer Sensor mit jeweils einem Prüftaster verbunden ist. Insbesondere bei der Überwachung von verwinkelten oder großen Räumen ist das Vorsehen von mehreren optischen Sensoren zur Detektion von Störlichtbögen von Vorteil. Dabei ist es bevorzugt, dass für jeden optischen Sensor ein Prüftaster und vorzugsweise ferner ein Leuchtmittel vorgesehen ist, so dass jeder optische Sensor unabhängig von den anderen optischen Sensoren einer Funktionsprüfung unterzogen werden kann.

Die Ausgestaltung und Funktion der zwei, drei oder mehreren optische Sensoren und vorzugsweise der zwei, drei oder mehreren Prüftaster soei vorzugsweise der zwei, drei oder mehreren Leuchtmittel entspricht vorzugsweise der zuvor und/oder im Folgenden beschriebenen Ausgestaltung und Funktion des (ersten) Sensors bzw. (ersten) Prüftasters bzw. (ersten) Leuchtmittels.

Ferner ist bevorzugt, dass der optische Sensor mindestens ein Detektionsmedium zum Detektieren eines Prüflichtstrahls oder eines Störlichtbogens aufweist. Das Detektionsmedium weist vorzugsweise an seiner Oberfläche eine Vielzahl von Photozellen auf. Einfallendes Licht durch einen Störlichtbogen oder ein Leuchtmittel bewirken einen photoelektrischen Effekt in den Photozellen. Treffen die aus der Photokathode herausgelösten Elektronen die Anode, so tritt ein messbarer Photostrom auf, der vorzugsweise als Detektionssignal für die Schalteinrichtung dient. Alternativ kann das Detektionsmedium auch eine Photodiode oder ein Phototransistor sein.

Besonders bevorzugt ist, dass ein Prüfabschnitt des Detektionsmediums senkrecht zu dem von dem Leuchtmittel emittierten Prüflichtstrahl angeordnet ist. Der Prüfabschnitt ist vorzugsweise aus dem gleichen Material und weist die gleichen Eigenschaften auf wie das übrige Detektionsmedium. Alternativ kann der Prüfabschnitt des Detektionsmediums auch ein anderes Material und/oder andere Eigenschaften als das übrige Detektionsmedium aufweisen, und beispielsweise auf eine von einem Störlichtbogen abweichende Lichtintensität des Prüflichtstrahls angepasst sein. Der von dem Leuchtmittel ausgesandte Prüflichtstrahl trifft vorzugsweise orthogonal auf den Prüfabschnitt des Detektionsmediums auf.

Ferner ist bevorzugt, dass ein erster und ein zweiter Abschnitt des Detektionsmediums V-förmig zueinander angeordnet sind, wobei vorzugsweise eine Kante des ersten Abschnitts eine Kante eines zweiten Abschnitts berührt. Der erste Abschnitt weist vorzugsweise die Form eines Quaders mit geringer Höhe auf und entspricht hinsichtlich des Aufbaus, der Form, der Größe und der spezifischen Eigenschaften vorzugsweise dem zweiten Abschnitt des Detektionsmediums. Somit weisen die Abschnitte jeweils zwei größere und vier kleinere rechteckige Flächen auf, wobei vorzugsweise jeweils eine größere rechteckige Fläche eines jeden Abschnittes eine Fläche für die Photozellen bereitstellt. Optional liegt ein Rand des ersten Abschnitts an einem Rand eines zweiten Abschnittes an. beiden Abschnitte sind vorzugsweise dachförmig zueinander angeordnet.

Insbesondere ist eine Anordnung von Abschnitten des Detektionsmediums bevorzugt, welche sicherstellt, dass der optische Sensor in der Lage ist, Störlichbögen zu detektiren, die in einem Bereich von bis zu 180°, vorzugsweise von bis zu 360° einfallen. Für eine Überwachung bis zu 180° ist die zuvor beschriebene dachförmige Anordnung von zwei Abschnitten von Detektionsmedium bevorzugt. Für die Überwachung in einem Bereich von 360° können mehrere Sensoren vorgesehen sein oder aber beispielsweise ein optischer Sensor mit zwei weiteren, dachförmig angeordneten Abschnitten von Detektionsmedium um 90° versetzt zu den ersten beiden Abschnitten.
Des Weiteren ist bevorzugt, dass der erste und der zweite Abschnitt des Detektionsmediums einen Winkel von 5° bis 175° bilden. Vorzugsweise beträgt der Winkel zwischen den beiden dachförmig zueinander angeordneten Abschnitten 90°. Je nach Anordnung der elektrotechnischen Geräte in einem Raum, kann der Winkel zwischen den Abschnitten aber auch Werte zwischen 5° und 175° annehmen, so dass ein senkrecht auf den Abschnitten stehender Vektor in die Richtung der elektrotechnischen Anlagen gerichtet ist. Insbesondere ist bevorzugt, dass der erste und der zweite Abschnitt des Detektionsmediums einen Winkel zwischen 30° bis 150°, insbesondere zwischen 45° und 135°, beispielsweise zwischen 60° und 120° bilden

Ferner ist eine Ausgestaltung bevorzugt, bei der sich der Prüfabschnitt von dem ersten und/oder dem zweiten Abschnitt des Detektionsmediums erstreckt, wobei der Prüfabschnitt vorzugsweise orthogonal zu der Längsrichtung des ersten und zweiten Detektionsmediums angeordnet ist. Die Längsrichtung verläuft parallel zu den Längsseiten des Detektionsmediums. Der erste Abschnitt und der zweite Abschnitt bilden einen Winkel, in welchem der Prüfabschnitt mittig angeordnet ist, auf eine Weise, dass die vom Prüfabschnitt gebildete Fläche orthogonal zu den durch den ersten und zweiten Abschnitt gebildeten Flächen steht.

Ferner ist bevorzugt, dass die erste Baugruppe in einem Gehäuse angeordnet ist, welches vorzugsweise transparentes Material aufweist oder daraus besteht. Das Gehäuse besteht vorzugsweise aus transparentem Kunststoff. Das Leuchtmittel, das Detektionsmedium und der Prüfabschnitt sind vorzugsweise innerhalb des Gehäuses durch Klebe- und/oder Lötverbindungen angeordnet. Alternativ kann das Gehäuse dadurch gebildet werden, dass flüssiger Kunststoff in eine Form gegossen wird, in der sich das Leuchtmittel, der Prüfabschnitt und das Detektionsmedium befinden. Beim Aushärten des flüssigen Kunststoffes sind die Bauteile in dem Kunststoff eingebettet und liegen mit ihren äußeren Flächen an dem Kunststoff an. Des Weiteren ist denkbar, dass das Gehäuse nur teilweise aus transparentem Material besteht. Beispielsweise könnte nur der Teil des Gehäuses auf transparentem Material bestehen, durch den einfallendes Licht auf das Detektionsmedium gelangen soll.

Des Weiteren ist eine Ausgestaltung bevorzugt, bei der in dem Gehäuse eine Abschirmung angeordnet ist, welche das Leuchtmittel zumindest teilweise umgibt. Die Abschirmung ist vorzugsweise ausgebildet, das Austreten des emittierenden Prüflichtsignals aus dem Gehäuse zumindest teilweise zu verhindern. Die Abschirmung ist vorzugsweise derart um das Leuchtmittel montiert, dass der vom Leuchtmittel emittierte Prüflichtstrahl zwar auf den Prüfabschnitt einfällt, jedoch kein Licht oder nur Licht mit geringer Intensität aus dem Gehäuse austritt, um das Auslösen eines zweiten Störlichtbogensensor zu unterbinden.

Gemäß einem weiteren Aspekt der Erfindung wird die eingangs genannte Aufgabe gelöst durch ein Verfahren zum Detektieren von Störlichtbögen, umfassend die Schritte: Bereitstellen eines optischen Sensors, welcher ausgebildet ist, um einen Störlichtbogen zu detektieren und bei Detektion eines Störlichtbogens ein Detektionssignal zu generieren und zu senden, Bereitstellen einer Schalteinrichtung, Bereitstellen eines Leuchtmittels, Bereitstellen eines Prüftasters, Betätigen des Prüftasters zum Emittieren eines Prüflichtstrahls von dem Leuchtmittel, Detektieren des von dem Leuchtmittel emittierten Prüflichtstrahls mittels des optischen Sensors, Generieren und Senden eines Detektionssignals durch den optischen Sensor bei Detektion des Prüflichtstrahls, Trennen einer elektrisch leitenden Verbindung durch die Schalteinrichtung bei Empfang des Detektionssignals.

Das erfindungsgemäße Verfahren und seine Fortbildungen weisen Merkmale bzw. Verfahrensschritte auf, die sie insbesondere dafür geeignet machen, für ein erfindungsgemäße Vorrichtung zur Detektion von Störlichtbögen und ihre Fortbildungen verwendet zu werden. Zu den Vorteilen, Ausführungsvarianten und Ausführungsdetails dieses Verfahren und seiner Fortbildungen wird auf die vorangegangene Beschreibung zu den entsprechenden Vorrichtungsmerkmalen verwiesen.

Eine bevorzugte Ausführungsform der Erfindung wird beispielshaft anhand der beiliegenden Figuren beschrieben. Es zeigen:
- Fig. 1:: eine beispielhafte Ausführungsform einer Vorrichtung zur Detektion von Störlichtbögen;
- Fig. 2:: eine Draufsicht auf den optischen Sensor der in Fig. 1 gezeigten Vorrichtung,
- Fig. 3:: eine längsgeschnittene Ansicht des optischen Sensors gemäß Fig. 2;
- Fig. 4:: eine erste Seitenansicht des optischen Sensors gemäß Fig. 2; und
- Fig. 5:: eine zweite Seitenansicht des optischen Sensors gemäß Fig. 2.

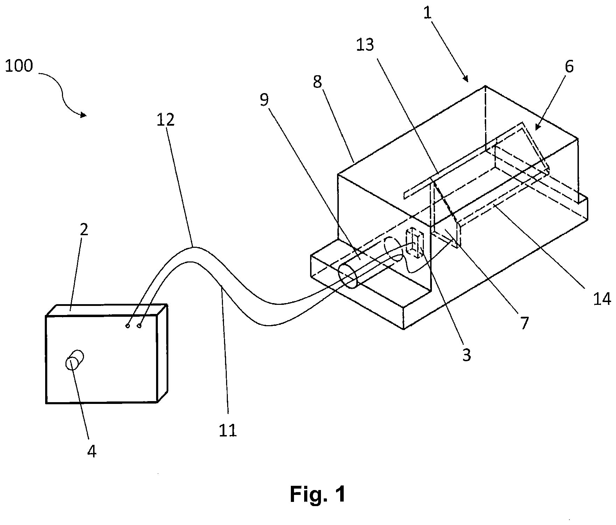

In Figur 1 ist eine Vorrichtung 100 zur Detektion von Störlichtbögen dargestellt. Die Vorrichtung 100 umfasst einen optischer Sensor 1 und ein Leuchtmittel 3, welche zu einer ersten Baugruppe zusammengefasst sind. Ferner umfasst die Vorrichtung 100 eine eine Schalteinrichtung 2 und einen Prüftaster 4, die eine zweite Baugruppe bilden. Die erste und die zweite Baugruppe sind signaltechnische miteinander über Kabel 11 und 12 verbunden.

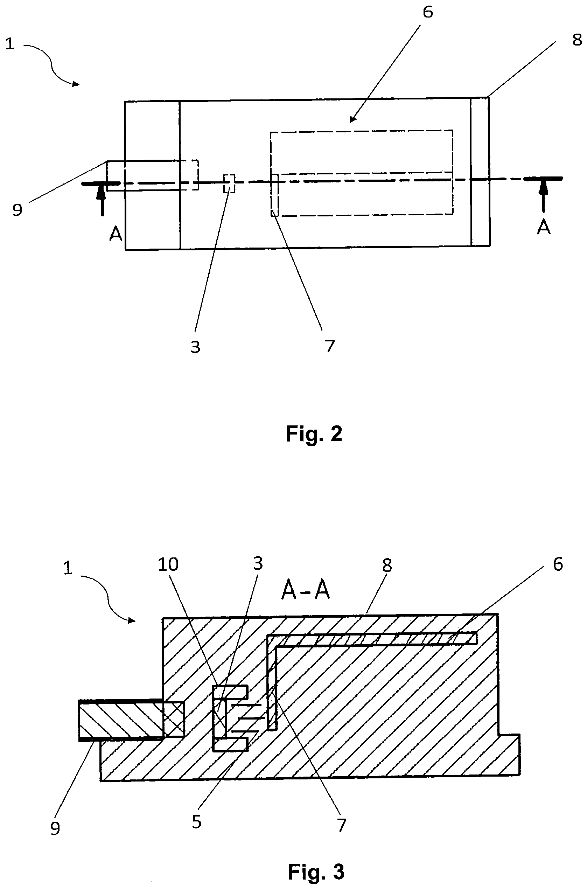

In den Figuren 2 bis 5 ist der optische Sensor 1 näher dargestellt. Gleiche oder im Wesentlichen funktionsgleiche Elemente werden mit den gleichen Bezugszeichen bezeichnet.

In der in Figur 1 dargestellten Ausführungsform ist der Prüftaster 4 in der Schalteinrichtung 2 integriert. Der Prüftaster 4 weist eine zylindrische Form auf und ragt aus einer Oberfläche der Schalteinrichtung 2 hervor, so dass dieser durch eine Person manuell betätigt werden kann.

Über ein erstes Kabel 11 ist der in der Schalteinrichtung 2 integrierte Prüftaster 4 mit dem Leuchtmittel 3 verbunden. Die Schalteinrichtung 2 ist mittels eines zweiten Kabels 12 mit einem Detektionsmedium 6 des optischen Sensors verbunden. Über eine Zuleitung 9 ist gewährleistet, dass die Kabel 11 und 12 in das Gehäuse 8 gelangen. Die Zuleitung 9, das Leuchtmittel 3, die beiden Abschnitte 13, 14 des Detektionsmediums und der Prüfabschnitt 7 des Detektionsmediums sind innerhalb eines Gehäuses 8 montiert.

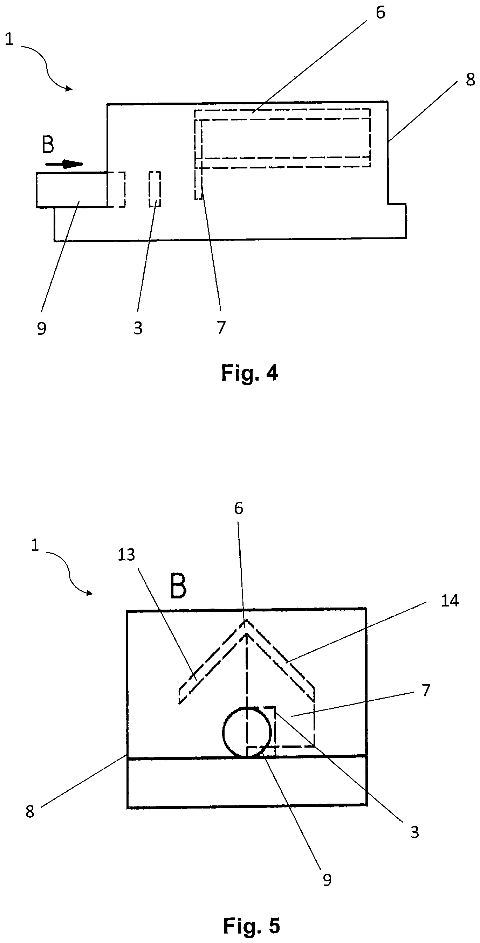

Ein erster Abschnitt 13 und ein zweiter Abschnitt 14 des Detektionsmediums 6 sind V-förmig zueinander angeordnet und bilden einen Winkel von 90°, wie insbesondere in Fig. 5 zu erkennen ist. Eine Kante des ersten Abschnitts 13 berührt eine zweite Kante des zweiten Abschnitts 14 des Detektionsmediums 6. In den beiden sich berührenden Kanten liegt die Längsrichtung des Detektionsmediums 6. Senkrecht zu der Längsrichtung des Detektionsmediums 6 erstreckt sich ein Prüfabschnitt 7, welcher in dem durch die Abschnitte des Detektionsmediums 6 eingeschlossenem Winkelbereich angeordnet ist.

Die Figur 2 zeigt eine längsgeschnittene Ansicht des in Figur 1 dargestellten optischen Sensors 1. Innerhalb des Gehäuses 8 sind das Detektionsmedium 6, der Prüfabschnitt 7, das Leuchtmittel 3 und eine Abschirmung 10 angeordnet. Der von dem Leuchtmittel 3 emittierte Prüflichtstrahl 5 trifft senkrecht auf den Prüfabschnitt 7 auf. Damit der Prüflichtstrahl 5 des Leuchtmittels 3 im Wesentlichen nur auf den Prüfabschnitt einfällt, umschließt eine Abschirmung 10 das Leuchtmittel 3 teilweise. Diese Abschirmung 10 und den von dem Leuchtmittel 3 emittierten Prüflichtstrahl 5 sind nur in Fig. 3 dargestellt, die Figuren 1, 2, 4 und 5 zeigen den optischen Sensor 1 ohne Abschirmung 10 und ohne Prüflichtstrahl 5.

## Patentansprüche

1. Vorrichtung zur Detektion von Störlichtbögen, umfassend:
- einen optischen Sensor (1), welcher ausgebildet ist, um einen Störlichtbogen zu detektieren und bei Detektion eines Störlichtbogens ein Detektionssignal zu generieren und zu senden,
- eine Schalteinrichtung (2), die ausgebildet ist, eine elektrisch leitende Verbindung zu trennen,
- ein Leuchtmittel (3),
**dadurch gekennzeichnet, dass** die Vorrichtung
- einen Prüftaster (4) aufweist,
wobei das Leuchtmittel (3) ausgebildet ist, bei Betätigung des Prüftasters (4) einen Prüflichtstrahl (5) zu emittieren, und
wobei der optische Sensor (1) ausgebildet ist, den von dem Leuchtmittel (3) emittierten Prüflichtstrahl (5) zu detektieren und bei Detektion des Prüflichtstrahls (5) ein Detektionssignal zu generieren und zu senden, und
wobei die Schalteinrichtung (2) ausgebildet ist, bei Empfang des Detektionssignals die elektrisch leitende Verbindung zu trennen.

2. Vorrichtung nach Anspruch 1,
wobei die Vorrichtung ausgebildet ist, im Mittelspannungsbereich, vorzugsweise bei Mittelspannungsschaltanlagen von Windenergieanlagen, eingesetzt zu werden.

3. Vorrichtung nach mindestens einem der vorhergehenden Ansprüche,
wobei der optische Sensor (1) und das Leuchtmittel (3) einer ersten Baugruppe zugeordnet sind, und
die Schalteinrichtung (2) und/oder der Prüftaster (4) einer zweiten Baugruppe zugeordnet sind, wobei vorzugsweise die erste Baugruppe und die zweite Baugruppe voneinander räumlich getrennt sind.

4. Vorrichtung nach mindestens einem der vorhergehenden Ansprüche,
wobei die erste Baugruppe und die zweite Baugruppe, vorzugsweise signaltechnisch, miteinander verbunden sind, insbesondere kabellos oder kabelgebunden.

5. Vorrichtung nach mindestens einem der vorhergehenden Ansprüche,
wobei das emittierte Prüflichtsignal (5) eine Lichtintensität von 400 cd bis 2000 cd aufweist.

6. Vorrichtung nach mindestens einem der vorhergehenden Ansprüche,
wobei das Leuchtmittel (3) eine Leuchtdiode ist, die vorzugsweise in SMD-Bauweise hergestellt ist.

7. Vorrichtung nach mindestens einem der vorhergehenden Ansprüche,
wobei der Prüftaster (4) und/oder eine Stromquelle in der Schalteinrichtung (2) integriert sind.

8. Vorrichtung nach mindestens einem der vorhergehenden Ansprüche,
**gekennzeichnet durch** zwei, drei oder mehrere optische Sensoren (1) und vorzugsweise zwei, drei oder mehrere Prüftaster (4).

9. Vorrichtung nach mindestens einem der vorhergehenden Ansprüche,
wobei der optische Sensor (1) mindestens ein Detektionsmedium (6) zum Detektieren eines Prüflichtstrahls (3) oder eines Störlichtbogens aufweist.

10. Vorrichtung nach mindestens einem der vorhergehenden Ansprüche,
wobei ein Prüfabschnitt (7) des Detektionsmediums (6) senkrecht zu dem von dem Leuchtmittel (3) emittierten Prüflichtstrahl (5) angeordnet ist.

11. Vorrichtung nach mindestens einem der vorhergehenden Ansprüche,
wobei ein erster und ein zweiter Abschnitt des Detektionsmediums (6) V-förmig zueinander angeordnet sind, wobei vorzugsweise eine Kante des ersten Abschnitts eine Kante des zweiten Abschnitts berührt, und wobei vorzugsweise der erste und der zweite Abschnitt des Detektionsmediums (6) einen Winkel von 5° bis 175° bilden.

12. Vorrichtung nach mindestens einem der Ansprüche 10 bis 11,
wobei sich der Prüfabschnitt (7) von dem ersten und/oder dem zweiten Abschnitt des Detektionsmediums (6) erstreckt, wobei der Prüfabschnitt (7) vorzugsweise orthogonal zu der Längsrichtung des ersten oder zweiten Detektionsmediums (6) angeordnet ist.

13. Vorrichtung nach mindestens einem der vorhergehenden Ansprüche 3 bis 12,
wobei die erste Baugruppe in einem Gehäuse (8) angeordnet ist, welches vorzugsweise transparentes Material aufweist oder daraus besteht.

14. Vorrichtung nach mindestens einem der vorhergehenden Ansprüche,
wobei in dem Gehäuse (8) eine Abschirmung (10) angeordnet ist, welche das Leuchtmittel (3) zumindest teilweise umgibt.

15. Verfahren zum Detektieren von Störlichtbögen, umfassend die Schritte:
- Bereitstellen eines optischen Sensors (1), welcher ausgebildet ist, um einen Störlichtbogen zu detektieren und bei Detektion eines Störlichtbogens ein Detektionssignal zu generieren und zu senden,
- Bereitstellen einer Schalteinrichtung (2),
- Bereitstellen eines Leuchtmittels (3),
- Bereitstellen eines Prüftasters (4),
- Betätigen des Prüftasters (4) zum Emittieren eines Prüflichtstrahls (5) von dem Leuchtmittel (3),
- Detektieren des von dem Leuchtmittel (3) emittierten Prüflichtstrahls (5) mittels des optischen Sensors (1),
- Generieren und Senden eines Detektionssignals durch den optischen Sensor (1) bei Detektion des Prüflichtstrahls (5),
- Trennen einer elektrisch leitenden Verbindung durch die Schalteinrichtung (2) bei Empfang des Detektionssignals.

## Claims

1. Device for detecting arcing faults, comprising,
- an optical sensor (1) which is designed to detect an arcing fault and when an arcing fault is detected to generate and transmit a detection signal,
- a switching device (2) which is designed cut an electrically conducting connection,
- a lighting means (3),
**characterised in that** that the device
- has a test button (4), wherein the lighting means (3) is designed to emit a testing light beam (5) when the test button (4) is actuated, and wherein the optical sensor (1) is designed to detect the testing light beam (5) emitted from the lighting means (3) and when the testing light beam (5) is detected to generate and transmit a detection signal, and wherein the switching device (2) is designed, when the detection signal is received, to cut the electrically conducting connection.

2. Device according to claim 1, wherein the device is designed for use in the medium voltage range, preferably in the case of medium voltage switchgear belonging to wind energy plants.

3. Device according to at least one of the preceding claims, wherein the optical sensor (1) and the lighting means (3) belong to a first construction group, and the switching device (2) and/or the test button (4) belong to a second construction group, wherein preferably the first construction group and the second construction group are spatially separated from one another.

4. Device according to at least one of the preceding claims, wherein the first construction group and the second construction group, preferably with regards to signalling, are connected with one another, in particular wirelessly or wired.

5. Device according to at least one of the preceding claims, wherein the emitted testing light beam (5) has a light intensity of 400 cd to 2000 cd.

6. Device according to at least one of the preceding claims, wherein the lighting means (3) is a light diode, which is preferably manufactured in SMD design.

7. Device according to at least one of the preceding claims, wherein the test button (4) and/or an electricity source are integrated in the switching device (2).

8. Device according to at least one of the preceding claims, **characterised by** two, three or more optical sensors (1) and preferably two, three or more test buttons (4).

9. Device according to at least one of the preceding claims, wherein the optical sensor (1) has at least one detection medium (6) for detecting a testing light beam (3) or an arcing fault.

10. Device according to at least one of the preceding claims, wherein a testing portion (7) of the detection medium (6) disposed perpendicularly to the testing light beam (5) emitted from the lighting means (3).

11. Device according to at least one of the preceding claims, wherein a first and a second section of the detection medium (6) are disposed in a V-shape to one another, wherein preferably one edge of the first section touches one edge of the second section, and wherein preferably the first and the second section of the detection medium (6) form an angle of 5° to 175°.

12. Device according to at least one of claims 10 to 11, wherein the testing portion (7) extends from the first and/or the second section of the detection medium (6), wherein the testing portion (7) is preferably orthogonally disposed to the longitudinal direction of the first or second detection medium (6).

13. Device according to at least one of the preceding claims 3 to 12, wherein the first construction group disposed in a housing (8) which preferably has transparent material or is made of such.

14. Device according to at least one of the preceding claims, wherein in the housing (8) is disposed a shield (10) which at least partially surrounds the lighting means (3).

15. Method for detecting arcing faults, comprising the steps:
- provision of an optical sensor (1) which is designed to detect an arcing fault and when an arcing fault is detected to generate and transmit a detection signal,
- provision of a switching device (2)
- provision of a lighting means (3),
- provision of a test button (4),
- actuation of the test button (4) to emit a testing light beam (5) from the lighting means (3),
- detection of the testing light beam (5) emitted from the lighting means (3) by means of the optical sensor (1),
- generation and transmission of a detection signal by means of the optical sensor (1) when the testing light beam (5) is detected,
- cutting of the electrically conducting connection by means of the switching device (2) when the detection signal is received.

## Revendications

1. Dispositif de détection d'arcs électriques parasites, comprenant :
- un capteur optique (1), qui est conçu pour détecter un arc électrique parasite et pour générer et émettre un signal de détection lors de la détection d'un arc électrique parasite,
- un dispositif commutateur (2) qui est conçu pour couper une liaison électriquement conductrice,
- un moyen d'éclairage (3),
**caractérisé en ce que** le dispositif
- comporte un bouton de test (4),
dans lequel le moyen d'éclairage (3) est réalisé pour émettre un rayon lumineux de test (5) lors de l'actionnement du bouton de test (4), et
dans lequel le capteur optique (1) est réalisé pour détecter le rayon lumineux de test (5) émis par le moyen d'éclairage (3) et pour produire et émettre un signal de détection lors de la détection du rayon lumineux de test (5), et
dans lequel le dispositif commutateur (2) est réalisé pour couper la liaison électriquement conductrice lors de la réception du signal de détection.

2. Dispositif selon la revendication 1,
dans lequel le dispositif est réalisé pour être utilisé dans la plage des moyennes tensions, de préférence dans des installations de distribution de moyenne tension d'installations d'énergie éolienne.

3. Dispositif selon au moins l'une quelconque des revendications précédentes,
dans lequel le capteur optique (1) et le moyen d'éclairage (3) sont associés à un premier module, et
le dispositif commutateur (2) et/ou le bouton de test (4) sont associés à un second module,
dans lequel, de préférence, le premier module et le second module sont séparés spatialement l'un de l'autre.

4. Dispositif selon au moins l'une quelconque des revendications précédentes,
dans lequel le premier module et le second module sont reliés l'un à l'autre, de préférence du point de vue de la technique de signalisation, en particulier sans fil ou de manière filaire.

5. Dispositif selon au moins l'une quelconque des revendications précédentes,
dans lequel le signal lumineux de test (5) émis a une intensité lumineuse comprise entre 400 cd et 2 000 cd.

6. Dispositif selon au moins l'une quelconque des revendications précédentes,
dans lequel le moyen d'éclairage (3) est une diode luminescente, qui est fabriquée de préférence avec la technique de construction des composants montés en surface (CMS).

7. Dispositif selon au moins l'une quelconque des revendications précédentes,
dans lequel le bouton de test (4) et/ou une source de courant sont intégrés dans le dispositif commutateur (2).

8. Dispositif selon au moins l'une quelconque des revendications précédentes,
**caractérisé par** deux, trois ou plus capteurs optiques (1) et de préférence deux, trois ou plus boutons de test (4).

9. Dispositif selon au moins l'une quelconque des revendications précédentes,
dans lequel le capteur optique (1) comporte au moins un moyen de détection (6) destiné à détecter un rayon lumineux de test (3) ou un arc électrique parasite.

10. Dispositif selon au moins l'une quelconque des revendications précédentes,
dans lequel une partie de test (7) du moyen de détection (6) est agencée perpendiculairement au rayon lumineux de test (5) émis par le moyen d'éclairage (3).

11. Dispositif selon au moins l'une quelconque des revendications précédentes,
dans lequel une première et une seconde partie du moyen de détection (6) sont agencées de manière à former mutuellement un V, dans lequel une arête de la première partie est de préférence en contact avec une arête de la seconde partie et dans lequel la première et la seconde partie du moyen de détection (6) forment de préférence un angle compris entre 5° et 175°.

12. Dispositif selon au moins l'une quelconque des revendications 10 à 11,
dans lequel la partie de test (7) s'étend à partir de la première partie et/ou de la seconde partie du moyen de détection (6), dans lequel la partie de test (7) est agencée de préférence perpendiculairement à la direction longitudinale du premier ou second moyen de détection (6).

13. Dispositif selon au moins l'une quelconque des revendications 3 à 12,
dans lequel le premier module est agencé dans un boîtier (8) qui comporte de préférence un matériau transparent ou en est constitué.

14. Dispositif selon au moins l'une quelconque des revendications précédentes,
dans lequel un écran (10), qui entoure au moins partiellement le moyen d'éclairage (3), est agencé dans le boîtier (8).

15. Procédé de détection d'arcs électriques parasites, comprenant les étapes :
- fourniture d'un capteur optique (1) qui est réalisé pour détecter un arc électrique parasite et pour produire et émettre un signal de détection lors de la détection d'un arc électrique parasite,
- fourniture d'un dispositif commutateur (2),
- fourniture d'un moyen d'éclairage (3),
- fourniture d'un bouton de test (4),
- actionnement du bouton de test (4) pour émettre un rayon lumineux de test (5) à partir du moyen d'éclairage (3),
- détection du rayon lumineux de test (5), émis par le moyen d'éclairage (3), au moyen du capteur optique (1),
- production et émission d'un signal de détection par le capteur optique (1) lors de la détection du rayon lumineux de test (5),
- coupure d'une liaison électriquement conductrice par le dispositif commutateur (2) lors de la réception du signal de détection.
